# EUROPEAN PATENT APPLICATION

(11) **EP 3 882 115 A1**
(43) Date of publication of application: **22.09.2021**
(21) Application number: 21163004.1
(22) Date of filing: 16.03.2021
(51) Int. Cl.: B62J 45/416, B62J 99/00, B62J 1/00

(54) **BICYCLE SADDLE WITH ZONAL COMPLIANCE**

(30) Priority: 17.03.2020 US 202016820837
(71) Applicant: Trek Bicycle Corporation, Waterloo, WI 53594 (US)
(72) Inventor: Baryudin, Alan, Waterloo, WI 53594 (US)
(74) Representative: J A Kemp LLP

(57) **Abstract**

A saddle design system includes a memory (215) configured to store saddle data, where the saddle data includes one or more rider-saddle pressure (800) values. The system also includes a processor (205) operatively coupled to the memory (215). The processor (205) is configured to analyze the one or more rider-saddle pressure (800) values. The processor (205) is also configured to generate a lattice design for a saddle base based at least in part on the analysis of the one or more rider-saddle pressure (800) values.

## Description

### BACKGROUND

A bicycle saddle, or seat, is a contact point of a bicycle that is used to support a portion of the cyclist's weight. A primary design consideration for a bicycle saddle is the amount of comfort it provides to the cyclist. To improve overall comfort, some traditional saddles include built in suspension (e.g., springs) that helps to absorb the impact experienced by the cyclist as the bicycle moves. Other design considerations include the overall weight of the saddle, the aesthetic appearance of the saddle, the ease of manufacturing the saddle, the amount of difficulty involved in making saddle adjustments by the cyclist, etc.

### SUMMARY

An illustrative saddle design system includes a memory configured to store saddle data, where the saddle data includes one or more rider-saddle pressure values. The system also includes a processor operatively coupled to the memory. The processor is configured to analyze the one or more rider-saddle pressure values. The processor is also configured to generate a lattice design for a saddle base based at least in part on the analysis of the one or more rider-saddle pressure values.

An illustrative bicycle saddle includes a saddle shell and a saddle base mounted to the saddle shell. The saddle base is in the form of a lattice that includes a first zone composed of a first plurality of interconnected ribs that result in a first peak rider-saddle pressure value for the first zone. The lattice of the saddle base also includes a second zone composed of a second plurality of interconnected ribs that result in a second peak rider-saddle pressure value for the second zone that differs from the first peak rider-saddle pressure value.

Other principal features and advantages of the invention will become apparent to those skilled in the art upon review of the following drawings, the detailed description, and the appended claims.

### BRIEF DESCRIPTION OF THE DRAWINGS

Illustrative embodiments will hereafter be described with reference to the accompanying drawings, wherein like numerals denote like elements. The foregoing and other features of the present disclosure will become more fully apparent from the following description and appended claims, taken in conjunction with the accompanying drawings. Understanding that these drawings depict only several embodiments in accordance with the disclosure and are, therefore, not to be considered limiting of its scope, the disclosure will be described with additional specificity and detail through use of the accompanying drawings.
Fig. 1 depicts a bicycle with a saddle constructed using zonal compliance in accordance with an illustrative embodiment.
Fig. 2 depicts a saddle design system in accordance with an illustrative embodiment.
Fig. 3 depicts a saddle base (or lattice) in accordance with an illustrative embodiment.
Fig. 4A depicts an initial pressure map generated on a saddle and based on sensor data in accordance with an illustrative embodiment.
Fig. 4B depicts the pressure map for a saddle designed using the saddle design application based on pressure reduction goals in accordance with an illustrative embodiment.
Fig. 5 depicts a saddle divided into zones in accordance with an illustrative embodiment.
Fig. 6 depicts a saddle with custom compliance zones in accordance with an illustrative embodiment.
Fig. 7 is a flow diagram depicting operations performed to make a saddle in accordance with an illustrative embodiment.
Fig. 8A is a plot that depicts median peak values of pressure extracted from saddle data in accordance with an illustrative embodiment.
Fig. 8B depicts a pressure map in accordance with an illustrative embodiment.
Fig. 8C depicts the pressure map superimposed on a saddle in accordance with an illustrative embodiment.
Fig. 9A depicts a plan view of a 3D saddle lattice base (or lattice) made using EPU40 in accordance with an illustrative embodiment.
Fig. 9B depicts a plan view of a 3D saddle base made using TPU1301 in accordance with an illustrative embodiment.
Fig. 10A depicts a saddle base mounted to a saddle shell with rails in accordance with an illustrative embodiment.
Fig. 10B depicts a saddle with a cover mounted over the saddle shell in accordance with an illustrative embodiment.
Fig. 11 is a cross-sectional view of a handlebar grip in accordance with an illustrative embodiment.

### DETAILED DESCRIPTION

It is well documented that different cyclists may have differing experiences with the same saddle due to riding style and other factors. For example, some cyclists tend to sit more towards the front of the saddle, some cyclists tend to sit more towards the rear of the saddle, and other cyclists tend to sit in the middle of the saddle. The weight, shape, size, injury history, etc. of the cyclist can also affect how he/she experiences the saddle. Described herein is a bicycle saddle that is designed and constructed such that different areas of the saddle have different compliance to improve overall comfort of the cyclist, as compared to traditional saddles. Specifically, the proposed bicycle saddle can provide in excess of a 50% reduction in peak pressure (between the cyclist and the saddle) as compared to traditional saddles. Using the techniques described herein, different saddles can be designed for different types of individual cyclists, such that comfort is maximized for all cyclists. Also described herein are systems for designing saddles based on desired saddle characteristics.

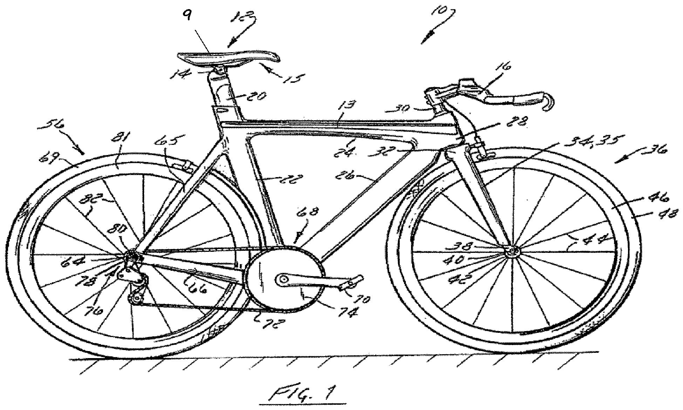

Fig. 1 depicts a bicycle 10 with a saddle 9 constructed using zonal compliance in accordance with an illustrative embodiment. As used herein, zonal compliance refers to the controlled variation of saddle compliance across a plurality of zones into which the saddle is divided. In alternative embodiments, the compliance of the saddle can be controlled without the use of separate zones. The bicycle 10 includes a frame 13 to which a saddle assembly 12 and handlebars 16 are attached. The saddle 9 is part of the saddle assembly 12. A saddle clamp 14 is engaged with an underside 15 of saddle assembly 12 and cooperates with a saddle post 20 that slidably engages a saddle tube 22 of frame 13. As such, the position of the saddle 9 is adjustable relative to the frame 13 to accommodate different riders. A top tube 24 and a down tube 26 extend forwardly from saddle tube 22 to a head tube 28 of frame 13.

Handlebars 16 of the bicycle 10 are connected to a steerer tube 30 that passes through head tube 28 and engages a fork crown 32. A pair of fork blades 34, 35 extend from generally opposite ends of fork crown 32 and are constructed to support a front wheel assembly 36 at an end thereof or fork tip 38. The fork blades 34, 35 can be part of a suspension bicycle fork or a rigid bicycle fork. As also shown in Fig. 1, fork tips 38 engage generally opposite sides of an axle 40 that is constructed to engage a hub 42 of front wheel assembly 36. A number of spokes 44 extend from hub 42 to a rim 46 of front wheel assembly 36. A tire 48 is engaged with rim 46 such that rotation of tire 48, relative to forks 34, rotates rim 46 and hub 42.

A rear wheel assembly 56 is positioned generally concentrically about a rear axle 64. A seat stay 65 and a chain stay 66 offset rear axle 64 from a crankset 68. The crankset 68 includes pedals 70 that are operationally connected to a flexible drive such as a chain 72 via a chain ring or sprocket 74. Rotation of the chain 72 communicates a drive force to a rear section 76 of the bicycle 10 having a gear cluster 78 positioned thereat. The gear cluster 78 is generally concentrically orientated with respect to the rear axle 64 and includes a number of variable diameter gears. The gear cluster 78 is operationally connected to a hub 80 associated with a rear tire 69 of rear wheel assembly 56. A number of spokes 82 extend radially between the hub 80 and a rim 81 that supports tire 69 of rear wheel assembly 56. As is commonly understood, rider operation of the pedals 70 drives the chain 72 thereby driving the rear tire 69 which in turn propels the bicycle 10.

In an illustrative embodiment, the saddle 9 of the bicycle 10 can be generated using a design system. The design system generates saddle designs, which can be used to make corresponding saddles through three-dimensional (3D) printing and/or other fabrication techniques. The design system can be used to generate custom saddle designs for individual users and mass market designs tailored to different groups of riders based on riding style, rider size, rider weight, rider sex, etc. As discussed in more detail below, the saddle design system can utilize a sensor system in some scenarios to detect pressure areas that result when a rider sits upon a saddle. These pressure areas can be identified for each of a plurality of zones of the saddle, or generally for the saddle as a whole. This pressure data is fed into a computer algorithm, where it can be analyzed by a human user and/or an automated algorithm to identify any areas of concern (e.g., areas in which the pressure between the rider and the saddle exceeds a pressure threshold). Areas of concern can also be identified based on rider feedback. If any areas of concern are identified, a pressure reduction goal is set for each identified area, and the reduction goals and original pressure data are fed into a saddle design application (or algorithm). The saddle design algorithm uses the pressure data and reduction goals to generate a saddle design that will result in reduced pressure in the areas of concern in accordance with the reduction goals.

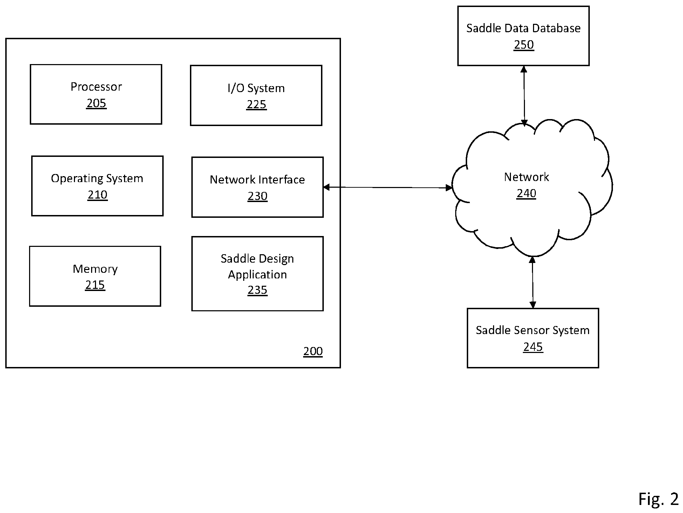

Fig. 2 depicts a saddle design system 200 in accordance with an illustrative embodiment. The saddle design system 200 is in the form of a computing system that includes a processor 205, an operating system 210, a memory 215, an I/O system 225, a network interface 230, and a saddle design application 235. In alternative embodiments, the saddle design system 200 may include fewer, additional, and/or different components. The components of the saddle design system 200 communicate with one another via one or more buses or any other interconnect system. In an illustrative embodiment, the saddle design system 200 can be part of a laptop computer, desktop computer, tablet, etc. The saddle design system 200 is in communication with a saddle sensor system 245 and a saddle data database 250 via a network 240. In an alternative embodiment, the saddle design system 200 can be in direct (wired) communication with the saddle sensor system 245 and/or the saddle data database 250. In another alternative embodiment, the saddle design system 200 may operate independent of the saddle sensor system 245 and/or the saddle data database 250.

The processor 205 can be any type of computer processor known in the art, and can include a plurality of processors and/or a plurality of processing cores. The processor 205 can include a controller, a microcontroller, an audio processor, a graphics processing unit, a hardware accelerator, a digital signal processor, etc. Additionally, the processor 205 may be implemented as a complex instruction set computer processor, a reduced instruction set computer processor, an x86 instruction set computer processor, etc. The processor 205 is used to run the operating system 210, which can be any type of operating system.

The operating system 210 is stored in the memory 215, which is also used to store programs, network and communications data, peripheral component data, the saddle design application 235, and other operating instructions. The memory 215 can be one or more memory systems that include various types of computer memory such as flash memory, random access memory (RAM), dynamic (RAM), static (RAM), a universal serial bus (USB) drive, an optical disk drive, a tape drive, an internal storage device, a non-volatile storage device, a hard disk drive (HDD), a volatile storage device, etc. In an alternative embodiment, the saddle data database 250 can be part of the memory 215.

The I/O system 225 is the framework which enables users and peripheral devices to interact with the saddle design system 200. The I/O system 225 can include a mouse, a keyboard, one or more displays, one or more touchscreens, a speaker, a microphone, etc. that allow the user to interact with and control the saddle design system 200. The I/O system 225 also includes circuitry and a bus structure to interface with peripheral computing devices such as power sources, USB devices, peripheral component interconnect express (PCIe) devices, serial advanced technology attachment (SATA) devices, high definition multimedia interface (HDMI) devices, proprietary connection devices, etc. In an illustrative embodiment, the I/O system 225 is configured to receive inputs and operating instructions from a user.

The network interface 230 includes transceiver circuitry that allows the saddle design system to transmit and receive data to/from other devices such as remote computing systems, servers, websites, the saddle sensor system 245, the saddle data database 250, etc. The network interface 230 enables communication through the network 240, which can be in the form of one or more communication networks and devices. For example, the network 240 can include a cable network, a fiber network, a cellular network, a wi-fi network, a landline telephone network, a microwave network, a satellite network, etc. and any devices/programs accessible through such networks. The network interface 230 also includes circuitry to allow device-to-device communication such as Bluetooth® communication.

The saddle design application 235 includes hardware and/or software, and is configured to perform any of the operations described herein to design a saddle. Software of the saddle design application 235 can be stored in the memory 215. The saddle design application 235 can be used to generate a saddle design based on saddle data that is received through the saddle sensor system 245 and/or the saddle data database 250. Alternatively, the saddle data can be received through user input and/or from any other source.

The saddle sensor system 245 is a bicycle saddle system that includes a plurality of pressure sensors incorporated therein or thereon. In one embodiment, the sensors can be attached to or formed into a saddle cover that mounts to the saddle base. Alternatively, the sensors can be mounted to or formed into the saddle base. The sensors can be individual sensors or in the form of a continuous sensor sheet, depending on the embodiment. In an illustrative embodiment, a rider can sit on the saddle sensor system 245 and pressure readings can be obtained to identify the amount of pressure between the rider and the saddle at every point of contact therebetween. For example, in one embodiment, 1440 sensor readings can be obtained. Alternatively, fewer or additional sensor readings may be used, such as 500, 1000, 1500, 2000, 3000, etc. In another alternative embodiment, pressure readings may be obtained for only a portion of the areas of contact between the rider and the saddle sensor system 245. For example, the pressure readings may be only from one or more specific zones into which the saddle is divided. In another embodiment, the pressure readings can result from the interaction of a simulated rider (e.g., a robot or robotic arm) and the saddle sensor system 245. Each of the pressure readings has an associated location that represents where on the saddle the pressure reading was sensed. These pressure readings and associated locations on the saddle form saddle data that is used by the saddle design application 235 to generate a saddle design.

For example, a rider that is experiencing discomfort while riding his/her bicycle can sit on the saddle sensor system 245 while riding a stationary (or regular) bicycle. While the rider is on the saddle sensor system 245, the sensors identify the areas of contact between the rider and the saddle and the amount of pressure at these areas. In an illustrative embodiment, the pressure is measured in Newtons/millimeter² (N/mm²). Alternatively, a different pressure unit may be used such as Pascals, etc. The processor 205 can use the data from the sensors to generate a pressure map that indicates the amount of pressure sensed at each area (or point) of contact between the rider and the saddle. As discussed herein, the saddle data can also come from simulated rider-saddle interactions, from stored data, from direct user feedback, etc.

The sensor data can be analyzed to identify high pressure contact areas between the rider and the saddle. Such high pressure contact areas can be identified as problem areas if the amount of detected pressure exceeds a pressure threshold. The pressure threshold, which can be 5 N/mm², 10 N/mm², 12 N/mm², 15 N/mm², 18 N/mm², 20 N/mm², etc. can vary for different riders, for different zones of the saddle, and/or different groups of riders. Direct feedback from the user can also be used to identify problem areas and other areas of concern for the rider. For example, the rider may have an injury or condition that results in pain from a relatively low pressure contact area between the rider and the saddle. Such areas can be identified by the rider and input into the system.

Once problem areas are identified, either automatically by the system or via input from the user, the system and/or a user can set one or more pressure reduction goals. Each pressure reduction goal indicates an amount by which pressure is to be reduced at a given area of the saddle (i.e., at a given contact area between the rider and the saddle). The pressure reduction goals can be in terms of a percentage reduction in pressure (e.g., a 5% pressure reduction, a 10% pressure reduction, a 20% pressure reduction, etc.) or an outright reduction in pressure (e.g., 5 less N/mm², 10 less N/mm², etc.).

In some embodiments, the pressure reduction goals can be set automatically by the system. For example, the system may automatically aim to reduce the peak pressure in a given zone (e.g., any zone of the saddle) or all zones on the saddle by a given percentage (e.g., 5%, 10%, 20%, etc.). Different zones and/or areas of the saddle can have different reduction goals. The pressure reduction goals can also be based on rider feedback based on where he/she is experiencing discomfort or looking for improvement in comfort. For example, the rider can specify a percentage reduction (or outright pressure reduction) in one or more areas of the saddle based on his/her experience and/or the pressure map associated with the rider experience.

The pressure reduction goals and saddle data (i.e., from the sensors and/or from the database) are provided to the saddle design application 235, which is programmed to determine a design for a saddle base in the form of a lattice. As used herein, the saddle base and the lattice are one and the same. Additional information can also be provided to the saddle design application 235 such as rider weight, rider size, characteristics of the material used to form the saddle base, the material from which the saddle shell is made, bicycle or saddle suspension characteristics, etc. The lattice design, once turned into a saddle, will result in a saddle base that has reduced rider-saddle pressure in accordance with the pressure reduction goals. In an illustrative embodiment, the lattice design is in the form of instructions for a 3D printer, and the 3D printer can be used to print a saddle base that matches the lattice design.

In another illustrative embodiment, the lattice design (and the resulting saddle base) is in the form of interconnected ribs (or struts). The ribs can form interconnected polygons, such as 3-sided shapes, 4-sided shapes, 5-sided shapes, 6-sided shapes, 8-sided shapes, 10-sided shapes, etc. Alternatively, the ribs can be in the form of continuous shapes such as circles, ovals, etc. The saddle design application 235 controls the compliance (or flexibility) of the saddle based on the hardness and flexibility of the material used to form the saddle and other factors. Specifically, the saddle design application 235 controls the thickness, shape, orientation, cross-sectional profile, and/or length of the ribs to impart the desired amount of compliance at each area (or zone) of the saddle based on the saddle data, the pressure reduction goals, known characteristics of the material used to form the saddle, etc. The material used to form the saddle can be an elastomeric polyurethane (EPU) (e.g., EPU40), a thermoplastic polyurethane (TPU) (e.g., TPU1301), or any other type of 3D printer material known in the art. In an alternative embodiment, the saddle base may be fabricated from a technique other than 3D printing.

In some embodiments, a strain rate hardening material may be used to construct the saddle base. An example of such a material is Rheon™ by RheonLabs. A strain rate hardening material is designed to stiffen as it gets impacted. Such materials can be made of strain-rate sensitive polymers that temporarily stiffen in response to an impact or other energy absorbing occurrence. This property allows for increased energy absorption by the material (e.g., saddle base), which results in less force transmitted into the rider that is in contact with the saddle base. This translates into a more comfortable riding experience for the rider. When used to form a saddle base, the geometry of the polymers that make up the material can be controlled to determine the amount of energy absorption at each zone or other desired area of the saddle base. Specifically, the saddle design application 235 can determine the amount of compliance that the strain rate hardening material will provide at each location of the saddle, taking into consideration the additional energy absorption afforded by the strain-rate sensitive nature of the material. A saddle formed with a strain rate hardening material can be made via 3D printing as described herein. Alternatively, the system can generate a design to form the saddle base with the strain rate hardening material through injection molding.

In one embodiment, the saddle design application 235 can use an iterative process to design a saddle. The iterative process can include designing a lattice, simulating what the compliance of the saddle will be for a rider, comparing the simulated compliance to a desired target compliance (i.e., based on the original saddle data and the reduction goal(s)), adjusting the lattice design based on the present and past simulation results in an effort to achieve the target compliance, and continuing this process until the target compliance is achieved for the saddle. The target compliance can be a plurality of compliance values (or reductions in pressure values) corresponding to a plurality of locations on the saddle. In an illustrative embodiment, the saddle can be divided into zones and compliance values for each zone can be considered independently in the iterative process.

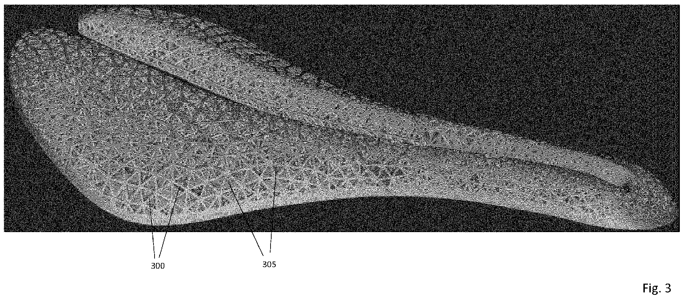

Fig. 3 depicts a printed saddle base (or lattice) in accordance with an illustrative embodiment. As shown the saddle base is formed from a plurality of interconnected ribs 300 that form interconnected polygons. In Fig. 3, at least a portion of the polygons are triangular in shape, although different shapes can be used in alternative embodiments as described herein. In an illustrative embodiment, a cross-section of each of the individual ribs 300 can be circular (i.e., the ribs are cylindrical in shape). Alternatively, the ribs 300 can have a different cross-sectional profile such as triangular, square, rectangular, ovular, pentagonal, etc. In some embodiment, different ribs in a given saddle can have different cross-sectional profiles to control the overall compliance of the saddle. As also shown, the interconnected ribs 300 form openings 305 having the shape of the polygon (or other shape) formed by the interconnected ribs. For example, in the embodiment of Fig. 3, the openings are triangular in shape. In alternative embodiments, different polygons can be used, resulting in different shaped openings. By controlling a size (e.g., diameter) of the ribs, a length of the ribs, a type of polygon formed by the ribs, a cross-sectional shape of the ribs, a size of the openings formed by the ribs, and/or the material used to form the ribs, the saddle design application 235 can control the compliance in different areas of the saddle as described herein.

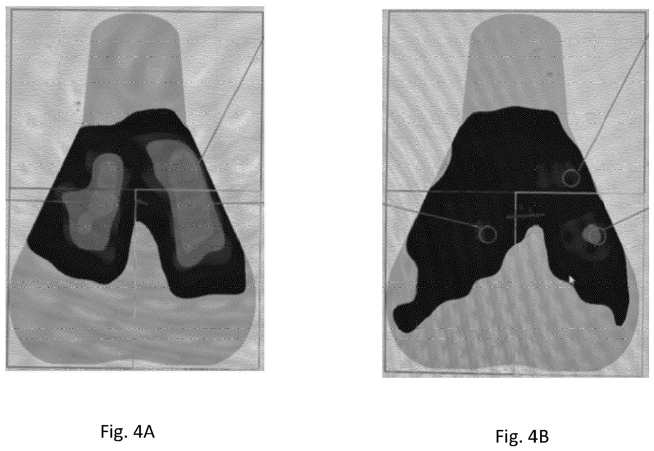

Figs. 4A and 4B illustrate before and after pressure maps for a rider that desired improved comfort in a saddle due to injury. Specifically, Fig. 4A depicts an initial pressure map generated on a saddle and based on sensor data in accordance with an illustrative embodiment. In the mapping of Fig. 4A, lighter shaded areas have higher pressure than the darker shaded areas. In an illustrative embodiment, each point of contact (as shown by the shading superimposed on the saddle) in the mapping is associated with a pressure value. The size of each point (or area) of contact depends on the resolution of the system, and can be in the range of one or more square microns, one or more square millimeters, etc.

The initial pressure map of Fig. 4A was provided to the saddle design application 235 along with pressure reduction goals associated with the rider. The pressure reduction goals were to maximally reduce the peak pressure experienced by the rider and to improve the rider's weight distribution on the saddle. The saddle design application 235 used this information to generate a lattice design for a saddle in accordance with the pressure reduction goals. The lattice design was used to 3D print a saddle base, and the saddle sensor system 245 was placed on the printed saddle base such that pressure between the rider and saddle could again be measured. Fig. 4B depicts the pressure map for a saddle designed using the saddle design application based on pressure reduction goals in accordance with an illustrative embodiment. As shown by the shading in Fig. 4B, the printed saddle resulted in a 39% reduction in peak rider-saddle pressure and increased weight distribution of the rider over the contact areas of the saddle.

In addition to individually customized saddles, the proposed system can also generate saddles that are intended to increase the comfort level for groups of riders. Saddle data used to generate such saddles can come from the saddle sensor system 245 and/or direct rider feedback from a plurality of users. The saddle design application 235 can also use saddle data from sources other than the saddle sensor system 245 to generate the lattice design. For example, the saddle data can be representative of desired rider-saddle pressure values for a given type of rider. This saddle data can be generated based on the feedback from riders, based on testing, based on known problem areas of a given saddle, etc. The saddle data can be stored in the saddle data database 250, the memory 215, or elsewhere, and can be provided to the saddle design application such 235 for the generation of saddle designs that are intended to accommodate groups of riders.

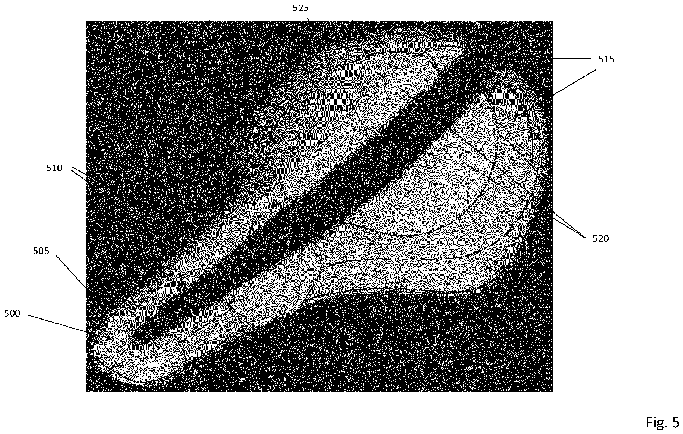

In an illustrative embodiment, the saddle can be divided into different zones, and saddle compliance can be considered on a zone-by-zone basis. Different zones can be of importance to different riders, depending on riding style, injury history, recent surgery, etc. Fig. 5 depicts a saddle 500 divided into zones in accordance with an illustrative embodiment. The saddle includes a nose zone 505, a rail zone 510, an edge zone 515, and an inner zone 520. As shown, the nose zone 505 includes the nose of saddle and extends distally (i.e., towards the rear of the saddle) along each of the saddle rails. The rail zone 510 is adjacent to the nose zone 505 and includes a first portion that extends along a first saddle rail and a second portion that extends along a second saddle rail. The edge zone 515 is adjacent to the rail zone 510 and includes first and second portions that form the rear outer edges on each side of the saddle 500. The inner zone 520 is adjacent to the edge zone 515 and includes first and second portions that form inner edges on each side of the saddle 500 next to a center opening 525 of the saddle 500. In alternative embodiments, a different number and/or shape/size of zones may be used. In another alternative embodiment, the saddles may be designed and manufactured without the use of zones. In yet another embodiment, the center opening 525 may not be included in the saddle.

In an illustrative embodiment, the compliance of the zones depicted in Fig. 5 can be controlled to design saddles that are effective and comfortable for individuals and for large groups of riders as a whole. For example, a saddle for an intermediate cyclist that sits in the middle of the saddle can be designed with the nose zone 505 as the softest zone for the saddle 500, having a compliance of ∼9 N/mm². The rail zone 510 and the inner zone 520 can be designed to have intermediate hardness, and can have a compliance of -12 N/mm², and the edge zone 515 can be designed to be the hardest portion of the saddle with a compliance of -18 N/mm². In alternative embodiments, different compliance values and/or zones may be used. For example, the compliance value in each zone can be adjusted up or down for different individuals and groups of riders to maximize comfort and support. In one embodiment, the edge zone 515 can be the stiffest zone to provide support to the sit bones of the rider and to create a cup that receives the bone structure of the rider. In alternative embodiments, portion(s) of one or more other zones may be stiffer than the edge zone 515 in the case of riders with injury, pain, recent surgery, etc.

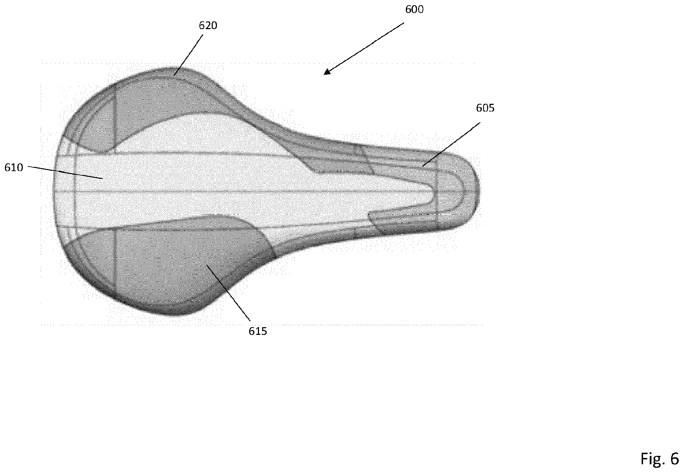

In one embodiment, a saddle can be designed based on customized compliance zones that are specific to a given rider or group of riders. For example, due to an existing condition, a rider may desire to have a saddle with one or more cutouts that eliminate (or virtually eliminate) pressure between the rider and saddle at various areas that would otherwise be points of contact. The one or more cutouts can form a zone that is used in conjunction with other zones to design a functional saddle. As an example, Fig. 6 depicts a saddle 600 with custom compliance zones in accordance with an illustrative embodiment. As shown, the saddle 600 includes a nose zone 605, a cutout zone 610, a first edge zone 615, and a second edge zone 620. The cutout zone 610 represents the area in which the rider (or group of riders) wishes to eliminate (or at least minimize) all pressure between the rider and the saddle. In alternative scenarios, a different size, shape, and/or location of the cutout zone may be desired. Using the proposed system, a saddle can be designed with minimized pressure (i.e., maximized compliance) in the cutout zone 610 using the techniques described herein.

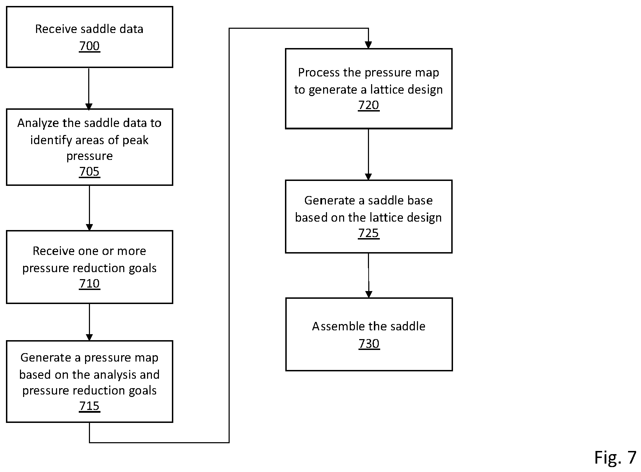

Fig. 7 is a flow diagram depicting operations performed to make a saddle in accordance with an illustrative embodiment. In alternative embodiments, fewer, additional, and/or different operations may be performed. Additionally, the use of a flow diagram is not meant to be limiting with respect to the order of operations performed. In one embodiment, the operations of Fig. 7 can be performed by components of the saddle design system 200 described herein with reference to Fig. 2. Alternatively, a different system may be used.

In an operation 700, the system receives saddle data. The saddle data can include compliance data that represents rider-saddle pressure that occurs as a result of contact between the rider and the saddle. The saddle data can also include the amount of saddle displacement that occurs due to the pressure. The pressure data can include static pressure data (i.e., pressure that occurs while the rider is not pedaling) and moving pressure data (i.e., pressure that occurs while the rider is pedaling). It has been determined that compliance in the various zones of the saddle is almost linear in nature. In one embodiment, the system can approximate compliance as a linear equation that relates a y-axis (load in Newtons) to an x-axis (displacement in mm). For example, the compliance of a nose zone of a foam saddle was found to be represented by the linear equation y = 15.784x - 10.647, with a coefficient of determination of R² = 0.9964. The compliance of a nose zone of a TPU lattice saddle base have 36% less compliance than the foam saddle was found to be represented by the linear equation y = 9.9817x - 8.2683, where R² = 0.9905.

The saddle data can also include information regarding the type of saddle that was used to generate the saddle data, the materials from which the saddle was made, the size and style of the saddle, the size of the rider, the riding style of the rider, etc. The saddle data can be received from direct rider input that is entered through an interface of the system, from local storage, from a remote database, from a sensor system that detects the pressures, etc. In one embodiment, the saddle data can be obtained based on use of a sensor system in conjunction with a robot (or other mechanical device) that is used to imitate the interaction between the saddle and the rider such that the saddle data is generated.

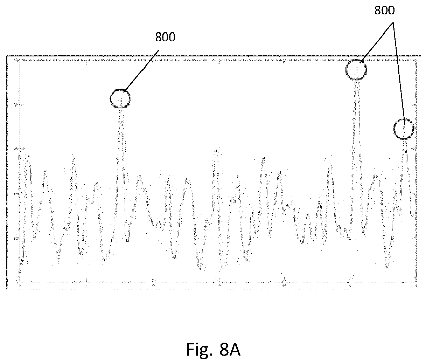

In an operation 705, the system analyzes the saddle data to identify areas of peak pressure. The system can also further analyze the saddle data to determine the median of the peak pressure values, smooth the pressure data, convert the saddle data into another format, etc. For example, in one embodiment, the system can filter the pressure data to remove outliers and smooth the dataset. Fig. 8A is a plot that depicts median peak values of pressure 800 extracted from saddle data in accordance with an illustrative embodiment. Extraction of the peak pressure values can be done separately for each zone of the saddle, or for the saddle as a whole, depending on the embodiment. In an alternative embodiment, the peak pressure values can be extracted from the saddle data without generation of a plot.

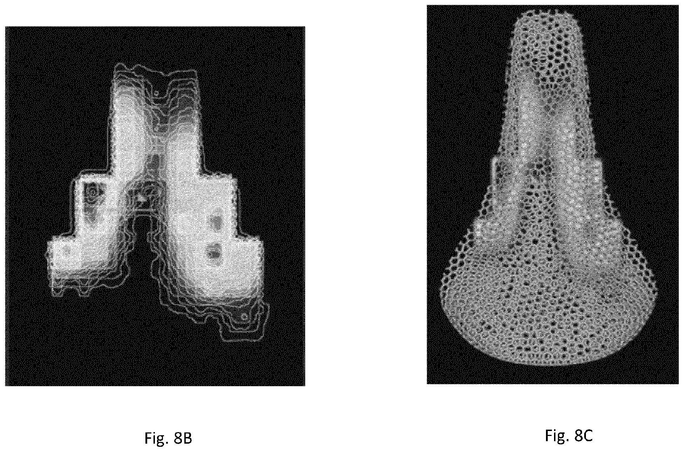

In an operation 715, the system generates a pressure map based on the analysis. The pressure map can include the pressure at every point of contact between the rider and the saddle, and can map that data to the position on the saddle where the contact occurred. The pressure map can be broken down into separate zones of the saddle in some embodiments. Also, the pressure map can be based on any number of pressure data points, such as 500 pressure readings, 1000 pressure readings, 1440 pressure readings, 2500 pressure readings, etc. Fig. 8B depicts a pressure map in accordance with an illustrative embodiment. Fig. 8C depicts the pressure map of Fig. 8B superimposed on a saddle in accordance with an illustrative embodiment.

In an operation 710, the system receives one or more pressure reduction goals. The pressure reduction goal(s) can be automatically generated by the system in one embodiment. Alternatively, the pressure reduction goal(s) can be specified by a rider and/or a saddle specialist, received from a local memory, received from a remote database, etc. As an example of reduction goals, the system can aim to achieve an X% reduction in pressure for one or more peak pressures identified in each of a plurality of saddle zones, where X can be 1, 2, 5, 10, 15, 20, 40, 50, etc. The pressure reduction goal can also be to minimize or even increase the pressure in a given zone or other area of the saddle. The pressure reduction goal can also be in terms of a pressure value such as a decrease of 2 N/mm² at a first location of the saddle, a decrease in pressure of 4 N/mm² at a second location of the saddle, etc. The pressure reduction goals can also be determined automatically based on predetermined pressure thresholds that are to not be exceeded. Each different area or zone of the saddle can have a different threshold. If this threshold is exceeded in a given area, the system can generate a pressure reduction goal for that area that brings the pressure to within the threshold in the saddle design.

In an alternative embodiment, the system can also design saddles based on desired amounts of pressure in each different zone or area of the saddle. Such saddle design can be done independent of any actual pressure readings and does not involve pressure reduction goals. Rather, in such an embodiment, the saddle data can be desired pressure values for each of a plurality of areas of the saddle, and the system can generate a saddle design that satisfies the desired pressure values.

In an operation 715, the system generates a pressure map based on the saddle data and the one or more pressure reduction goals. The pressure map can include the desired pressure at every point of contact between the rider and the saddle (i.e., based on the pressure data as reduced by the pressure reduction goals), and can map that data to the position on the saddle where the contact occurs. The pressure map can be broken down into separate zones of the saddle in some embodiments. Also, the pressure map can be based on any number of pressure data points, such as 500 pressure readings, 1000 pressure readings, 1440 pressure readings, 2500 pressure readings, etc. Fig. 8B depicts a pressure map in accordance with an illustrative embodiment. Fig. 8C depicts the pressure map of Fig. 8B superimposed on a saddle in accordance with an illustrative embodiment.

In an operation 720, the system processes the pressure map to generate a lattice design for a saddle. In an alternative embodiment, the system may not generate a pressure map, and can instead utilize raw data (i.e., the raw pressure data and pressure reduction goals) to generate the lattice design. In another alternative embodiment, the pressure map can be based on actual or desired rider-pressure data, and the system can process the pressure map and any pressure reduction goals to generate the lattice design. In such an embodiment, the pressure reduction goals are not incorporated into the pressure map.

The lattice design can be generated using the iterative design process described herein and/or any other data processing techniques. In an illustrative embodiment, data from the pressure map drives generation of the lattice design along with pressure reduction goals. As discussed herein, the lattice design is in the form of interconnected ribs (or struts) that form interconnected polygons and/or other shapes such as circles, ovals, etc. The compliance of the lattice design is controlled based in part on the hardness and flexibility of the material used to form the saddle. Specifically, taking the hardness and flexibility of the material into consideration, the system controls the thickness (e.g., diameter), orientation, cross-sectional profile, and/or length of the ribs to impart the desired amount of compliance in the saddle based on the saddle data and the pressure reduction goals. The lattice can also be generated based in part on the hardness/flexibility of a saddle shell to which the lattice saddle base is to be mounted, based on the suspension of the saddle system, based on a type of cover to be placed over the lattice, etc. The lattice can be generated on a zone-by-zone basis in one embodiment.

In an operation 725, the system generates a saddle base based on the lattice design. In an illustrative embodiment, the lattice design is in the form of 3D printer instructions that instruct a 3D printer how to print the saddle base. The saddle base can be a mesh lattice as described herein. The saddle base can printed as a 3D base or a two-dimensional (2D) base, depending on the implementation. A 2D saddle base refers to a flat lattice structure that is later formed around and mounted onto a saddle shell. A 3D saddle base refers to a preformed lattice structure that is constructed in the proper shape to directly mount onto the saddle shell without further forming/shaping.

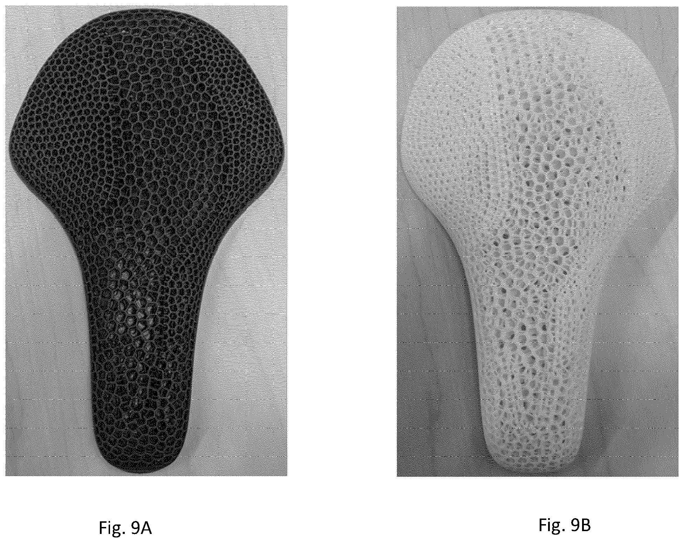

The material used to form the saddle can be an elastomeric polyurethane (EPU) (e.g., EPU40), a thermoplastic polyurethane (TPU) (e.g., TPU1301), or any other type of 3D printer material known in the art. Fig. 9A depicts a plan view of a 3D saddle lattice base (or lattice) made using EPU40 in accordance with an illustrative embodiment. Fig. 9B depicts a plan view of a 3D saddle base made using TPU1301 in accordance with an illustrative embodiment. In alternative embodiments, a different TPU material, a different EPU material, or a different type of material may be used to form the saddle. As shown in Figs. 9A and 9B, the ribs which make up the lattice have differing thicknesses, different lengths, and interconnect to form different types and sizes of polygon shapes depending on where they are positioned in the 3D lattice. This variation in ribs extends throughout the 3D structure and controls the compliance of the saddle lattice at each position thereof.

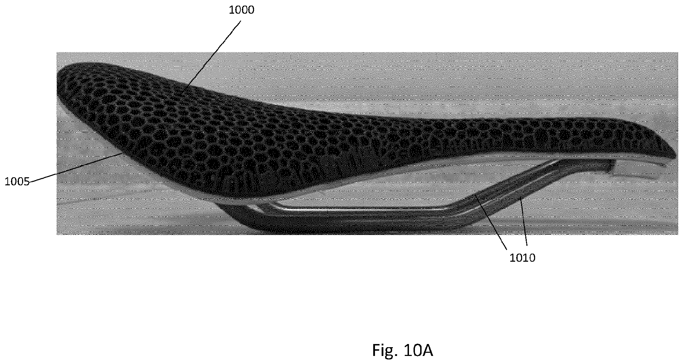

Referring again to Fig. 7, the saddle is assembled in an operation 730. The assembly can include mounting the saddle base to a saddle shell, mounting the saddle shell to saddle rails, and/or placing a cover over all or a portion of the saddle base. In embodiments in which the saddle base is a 2D lattice, assembly can also include forming the saddle base to fit the saddle shell. The 2D lattice can be formed using heat molding, baking, or any other techniques known in the art. During assembly, the saddle base (or lattice) can be mounted to a saddle shell, which can be made from nylon, carbon, composite material, etc. An adhesive such as contact cement or cyanoacrylate can be used to secure the saddle base to the saddle shell. Saddle rails can be mounted to the saddle shell using any techniques known in the art. Fig. 10A depicts a saddle base 1000 mounted to a saddle shell 1005 with rails 1010 in accordance with an illustrative embodiment.

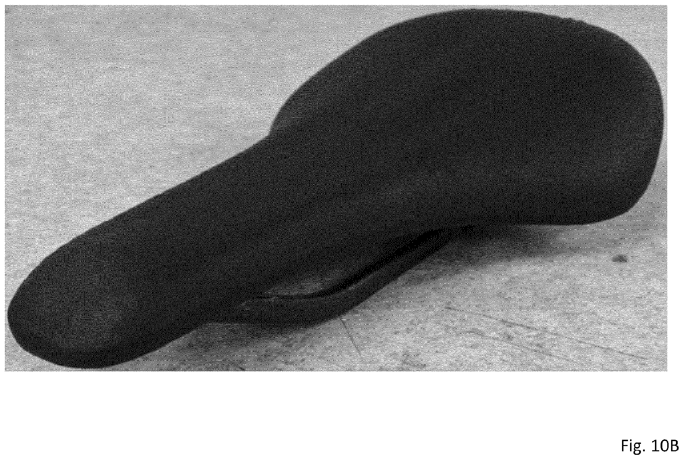

In some embodiments, the saddle shell can be wrapped with a material to cover the appearance of the lattice. The cover material can affect the compliance of the saddle, and in some embodiments, this effect from the cover can be taken into consideration during the lattice design operation. The cover, if used, can help protect the saddle from the elements and also from insects. The cover can be applied to the saddle shell using either a positive vacuum or a negative vacuum, depending on the embodiment. For a positive vacuum process, the cover material is vacuum formed over the lattice and simultaneously bonded to the shell. For a negative vacuum process, the cover material is vacuum formed into a cavity and the lattice is placed into the cavity and bonded to the cover material. The cover can be secured to the saddle shell using contact cement, a 2 part urethane, or another adhesive that will not significantly alter the compliance values of the lattice. The cover can also be wrapped onto the saddle shell and adhered to the saddle shell using contact cement or another adhesive. The cover can be a clear or colored TPU material, polyurethane soft touch material, or other material. Fig. 10B depicts a saddle with a cover mounted over the saddle shell in accordance with an illustrative embodiment. In alternative embodiments, a cover may not be used.

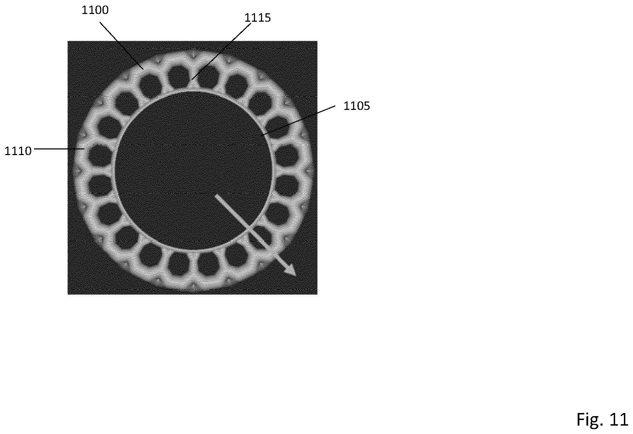

In another embodiment, a handlebar grip for a bicycle can be made from a 3D printed lattice. Using 3D print technology, the handlebar grip can be designed to buckle responsive to impact, which results in rotational movement that can reduce stress on the rider's hands, wrists, and arms. Fig. 11 is a cross-sectional view of a handlebar grip 1100 in accordance with an illustrative embodiment. The handlebar grip 1100, which is a single-piece grip, is designed to buckle at its inner diameter, and the buckling provides rotational movement of its outer diameter. The rotational movement dampens impact and reduces stress on the rider. An inner surface of an inner diameter 1105 of the handlebar grip 1100 mounts to a handlebar of a bicycle via a friction fit, adhesive, or other technique.

As shown by the arrow in Fig. 11, the handlebar grip 1100 has a thin to thick gradient, as indicated by the arrow. Specifically, the inner diameter 1105 of the handlebar grip 1100 is thin compared to an outer diameter 1110, which is thick. For example, the outer diameter can be 8 times thicker than the inner diameter, 10 times thicker, 12 times thicker, etc., depending on the desired amount of rotational damping for the handlebar grip 1100. The inner diameter 1105 and the outer diameter 1110 are connected to one another by a lattice formed of ribs 1115 extend therebetween. In an illustrative embodiment, the thickness and length of the ribs 1115 and the ratio of the thickness of the outer diameter 1110 to the thickness of the inner diameter 1105 are controlled to determine the amount of rotational damping provided by the handlebar grip 1100.

In an illustrative embodiment, the handlebar grip 1100 can be made using any of the techniques described herein with respect to the saddle. For example, grip data can be obtained based on user feedback, desired rider-grip pressure values for a given type of rider or terrain, and/or sensor data from a sensor system that detects rider-grip pressure. This grip data can be analyzed to identify areas of peak pressure on the grip, which can be divided into zones. Based on the peak pressure values, the system (or a user) can identify pressure reduction goals to reduce the rider-grip pressure at one or more areas or zones. The system can then be used to generate a grip design that achieves the pressure reduction goals. The grip design can then be 3D printed to generate the grip.

The word "illustrative" is used herein to mean serving as an example, instance, or illustration. Any aspect or design described herein as "illustrative" is not necessarily to be construed as preferred or advantageous over other aspects or designs. Further, for the purposes of this disclosure and unless otherwise specified, "a" or "an" means "one or more".

The foregoing description of illustrative embodiments of the invention has been presented for purposes of illustration and of description. It is not intended to be exhaustive or to limit the invention to the precise form disclosed, and modifications and variations are possible in light of the above teachings or may be acquired from practice of the invention. The embodiments were chosen and described in order to explain the principles of the invention and as practical applications of the invention to enable one skilled in the art to utilize the invention in various embodiments and with various modifications as suited to the particular use contemplated. It is intended that the scope of the invention be defined by the claims appended hereto and their equivalents.

The following are optional features of the disclosed saddle design system.

Optionally, the one or more rider-saddle pressure values comprise desired pressure values for a plurality of saddle zones.

Optionally, the saddle design system further comprises a transceiver operatively coupled to the processor, wherein the transceiver is configured to receive at least a portion of the saddle data from a saddle sensor system.

Optionally, the saddle data includes rider height, rider weight, or rider size.

Optionally, analysis of the one or more rider-saddle pressure values identifies an area of peak pressure. Optionally, the processor determines whether the area of peak pressure exceeds a pressure threshold. Optionally, the processor generates a pressure reduction goal for the area of peak pressure that exceeds the pressure threshold, wherein the processor uses the pressure reduction goal to generate the lattice design with reduced pressure at the area of peak pressure, and wherein the reduced pressure is within the pressure threshold.

Optionally, the processor is configured to generate a pressure map based at least in part on the analysis of the one or more rider-saddle pressure values.

Optionally, generation of the lattice design includes generation of instructions for a three-dimensional (3D) printer to print the lattice design. Optionally, the saddle design system further comprises the 3D printer, wherein the 3D printer is configured to print the lattice design to generate the saddle base.

Optionally, to generate the lattice design the processor determines a thickness of ribs that form the lattice design.

Optionally, to generate the lattice design the processor determines a length of ribs that form the lattice design.

Optionally, to generate the lattice design the processor determines a type of shape that is to be formed by interconnected ribs that form the lattice design. Optionally, to generate the lattice design the processor determines a size of an opening in the type of shape formed by the interconnected ribs that form the lattice design.

Optionally, the saddle data includes a type of material used to form a saddle shell to which the saddle base is to be mounted, and wherein the lattice design is generated based at least in part on the type of material.

The following are optional features of the bicycle saddle.

Optionally, at least a portion of the first plurality of interconnected ribs form a first plurality of shapes having first openings, and wherein at least a portion of the second plurality of interconnected ribs form a second plurality of shapes having second openings.

Optionally, the first openings differ in size from the second openings.

Optionally, the first plurality of shapes are of a different type than the second plurality of shapes.

Optionally, a first portion of the first plurality of interconnected ribs form a first plurality of shapes having first openings, wherein a second portion of the first plurality of interconnected ribs form a second plurality of shapes having second openings, and wherein the first openings differ in size from the second openings.

## Claims

1. A saddle design system comprising:
a memory configured to store saddle data, wherein the saddle data includes one or more rider-saddle pressure values; and
a processor operatively coupled to the memory, wherein the processor is configured to:
analyze the one or more rider-saddle pressure values; and
generate a lattice design for a saddle base based at least in part on the analysis of the one or more rider-saddle pressure values.

2. The saddle design system of claim 1, wherein the one or more rider-saddle pressure values comprise desired pressure values for a plurality of saddle zones.

3. The saddle design system of claim 1 or 2, further comprising a transceiver operatively coupled to the processor, wherein the transceiver is configured to receive at least a portion of the saddle data from a saddle sensor system.

4. The saddle design system of claim 1, 2 or 3, wherein analysis of the one or more rider-saddle pressure values identifies an area of peak pressure.

5. The saddle design system of claim 4, wherein the processor determines whether the area of peak pressure exceeds a pressure threshold.

6. The saddle design system of claim 5, wherein the processor generates a pressure reduction goal for the area of peak pressure that exceeds the pressure threshold, wherein the processor uses the pressure reduction goal to generate the lattice design with reduced pressure at the area of peak pressure, and wherein the reduced pressure is within the pressure threshold.

7. The saddle design system of any preceding claim, wherein the processor is configured to generate a pressure map based at least in part on the analysis of the one or more rider-saddle pressure values.

8. The saddle design system of any preceding claim, wherein generation of the lattice design includes generation of instructions for a three-dimensional (3D) printer to print the lattice design.

9. The saddle design system of any preceding claim, wherein to generate the lattice design the processor determines a thickness of ribs that form the lattice design and a length of ribs that form the lattice design.

10. The saddle design system of any preceding claim, wherein to generate the lattice design the processor determines a type of shape that is to be formed by interconnected ribs that form the lattice design, and wherein to generate the lattice design the processor determines a size of an opening in the type of shape formed by the interconnected ribs that form the lattice design.

11. A bicycle saddle comprising:
a saddle shell; and
a saddle base mounted to the saddle shell, wherein the saddle base is in the form of a lattice that includes:
a first zone composed of a first plurality of interconnected ribs that result in a first peak rider-saddle pressure value for the first zone; and
a second zone composed of a second plurality of interconnected ribs that result in a second peak rider-saddle pressure value for the second zone that differs from the first peak rider-saddle pressure value.

12. The bicycle saddle of claim 11, wherein at least a portion of the first plurality of interconnected ribs form a first plurality of shapes having first openings, and wherein at least a portion of the second plurality of interconnected ribs form a second plurality of shapes having second openings.

13. The bicycle saddle of claim 12, wherein the first openings differ in size from the second openings.

14. The bicycle saddle of claim 12 or 13, wherein the first plurality of shapes are of a different type than the second plurality of shapes.

15. The bicycle saddle of any one of claims 11 to 14, wherein a first portion of the first plurality of interconnected ribs form a first plurality of shapes having first openings, wherein a second portion of the first plurality of interconnected ribs form a second plurality of shapes having second openings, and wherein the first openings differ in size from the second openings.
